# EUROPEAN PATENT APPLICATION

(11) **EP 2 479 763 A1**
(43) Date of publication of application: **25.07.2012**
(21) Application number: 10817256.0
(22) Date of filing: 16.09.2010
(51) Int. Cl.: H01B 5/14, C23C 14/08

(54) **TRANSPARENT CONDUCTIVE FILM AND DEVICE COMPRISING SAME**

(30) Priority: 17.09.2009 JP 2009216259
(71) Applicant: Sanyo Electric Co., Ltd., Osaka 570-8677 (JP)
(72) Inventor: FUJISHIMA Daisuke, Moriguchi-shi Osaka 570-8677 (JP)
(74) Representative: Calderbank, Thomas Roger
(86) International application number: PCT/JP2010/066077
(87) International publication number: WO 2011/034143

(57) **Abstract**

The present invention provides a transparent conductive film (2) that is capable of absorbing less light of the long-wavelength side with good carrier mobility and a lower electric resistance; and a device which comprises the transparent conductive film. The transparent conductive film (2) contains indium oxide that contains hydrogen and cerium, which is substantially composed of polycrystalline structure. The transparent conductive film (2) has a specific resistance of 3.4 x 10⁻⁴

## Description

### FIELD OF THE INVENTION

The present invention relates to a transparent conductive film and a device with the same.

### BACKGROUND OF THE INVENTION

Transparent conductive films have been conventionally used in various devices such as display devices like liquid display devices, organic electroluminescence devices, solar cell devices like thin film solar cells, dye-sensitized solar cells, and electronic components.

It is preferable that the resistance of such a transparent conductive film is small. Conventionally, a transparent conductive film made from indium oxide containing tin (ITO) and a transparent conductive film made from zinc oxide (ZnO) and the like are known. Other than the transparent conductive film containing tin (ITO), a transparent conductive film made of indium oxide containing cerium added by a spattering method is disclosed as a transparent conductive film made from indium oxide, for example. (For instance, see patent publication 1)

### PRIOR ART

### Patent publication

Patent publication 1: Japanese Patent Publication Laid-open No. Hei8-260134

### SUMMARY OF THE INVENTION

### Problems to be solved by the invention

However, there has been a problem in making a transparent conductive film made of indium oxide containing cerium due to the difficulty in making the film absorb less light of the long-wavelength side, while having good carrier mobility and a lower electric resistance.

The present invention considers the above-identified problem and provides a transparent conductive film that is capable of absorbing less light of the long-wavelength side, has good carrier mobility and a lower electric resistance.

### Methods to solve the problems

An aspect of the present invention is a transparent conductive film that includes indium oxide containing hydrogen and cerium and has substantially polycrystalline structure, wherein the specific resistance is not greater than 3.4 x 10⁻⁴

According to the present invention, the transparent conductive film is capable of absorbing less light of the long-wavelength side, having good carrier mobility and lowering the electric resistance because the transparent conductive film includes indium oxide containing hydrogen and cerium and comprises a substantially polycrystalline structure, wherein the specific resistance is not greater than 3.4 x 10⁻⁴

Accordingly, when the present invention is applied in devices such as display devices like liquid display devices, organic electroluminescence devices, solar cell devices like crystalline solar cells, thin film solar cells, dye-sensitized solar cells, and electronic components, the performance of these devices can be improved.

### Effect of the invention

The invention provides a transparent conductive film capable of absorbing less light of the long-wavelength side, having good carrier mobility and lowering the electric resistance, and a device with the same.

### BRIEF DESCRIPTION OF THE DRAWINGS

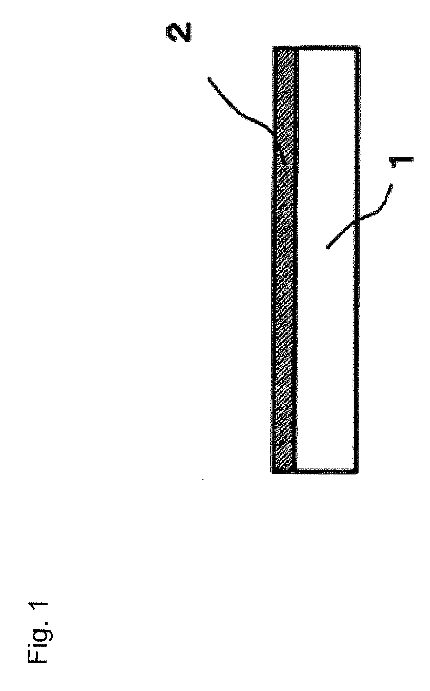

[Fig. 1] Fig. 1 is a sectional view of a transparent conductive film according to an embodiment of the present invention.
[Fig. 2] Fig. 2 is a table showing sintered bodies used for making respective transparent conductive films, types of substrates used, contents of cerium (Ce) and contents of hydrogen in respective transparent conductive films, the specific resistance of respective transparent conductive films, carrier mobility, and carrier density in examples 1-7 according to the embodiment, and in comparative examples 1-10.
[Fig. 3] Fig. 3 is a diagram showing the relationship between the cerium (Ce) concentration and the specific resistance in examples according to the embodiment, and in comparative examples.
[Fig. 4] Fig. 4 is a diagram showing the relationship between the cerium (Ce) concentration and the carrier mobility in examples according to the embodiment, and in comparative examples.
[Fig. 5] Fig. 5 is a diagram showing the relationship between the cerium (Ce) concentration and the carrier density in examples according to the embodiment, and in comparative examples.

### EMBODIMENTS TO ENABLE THE INVENTION

A transparent conductive film according to the present invention is explained below by referring to the figures.

1 is a substrate body formed by a glass substrate, polycrystalline silicon substrate, monocrystalline silicon substrate, and a substantially intrinsic i-type amorphous silicon layer and a p-type amorphous silicon layer, in this order. Namely, substrate body 1 has the p-type amorphous layer on the top surface and is formed by the monocrystalline silicon substrate and the like. 2 is a transparent conductive film formed on substrate body 1.

Transparent conductive film 2 is a film that includes indium oxide as an essential ingredient and also contains cerium (Ce) and hydrogen (H). Namely, transparent conductive film 2 includes hydrogen (H), cerium (Ce), indium (In), and oxygen (O), and contains indium oxide (In₂O₃) doped with hydrogen (H)and cerium (Ce)as impurities.

Transparent conductive film 2 is formed substantially by polycrystalline structures and contains numerous pillar-like structures bristled up to cover the substrate body. Further, transparent conductive film 2 contains a very little amount of amorphous portions.

A hydrogen (H) content in transparent conductive film 2 is preferably 1.0 x 10²¹ atoms/cm³ and more preferably is in the order of 10²¹ atoms/cm³. The hydrogen content here refers to an amount of hydrogen contained in the middle of transparent conductive film 2 in its thickness direction and is substantially the same as the average content in the film other than in the vicinities of both surfaces of transparent conductive film 2. The hydrogen content concentration is preferably greater in the substrate body 1 side than in the film surface side, and more preferably, the concentration increases gradually toward the substrate body 1 side.

The specific resistance of transparent conductive film 2 is not greater than 3.4 x 10⁻⁴ resistance of transparent conductive film 2, the better. However, the specific resistance may be between not greater than 3.4 x 10⁻⁴ less than 1.0 x 10⁻⁴

A cerium (Ce) content in transparent conductive film 2 is preferably between 1.0 x 10²⁰ atoms/cm³ or more and 1.4 x 10²¹ atoms/cm³ or less, and more preferably is between 2.4 x 10²⁰ atoms/cm³ or more and 1.2 x 10²¹ atoms/cm³ or less, and further more preferably is between 4.8 x 10²⁰ atoms/cm³ or more and 1.1 x 10²¹ atoms/cm³ or less, and still further more preferably is between 7.5 x 10²⁰ atoms/cm³ or more, and 1.0 x 10²¹ atoms/cm³ or less, and yet further more preferably is between 7.5 x 10²⁰ atoms/cm³ or more, and 8.5 x 10²⁰ atoms/cm³ or less.

Hereinafter, a method of manufacturing a transparent conductive film according to the embodiment is explained.

First, substrate body 1 is prepared by removing impurities on the surface by cleaning.

Note that in the case where substrate body 1 is a body including a substantially intrinsic i-type amorphous silicon layer and a p-type amorphous silicon layer formed on an n-type monocrystalline silicon substrate in this order, substrate body 1 is formed as follows: upon removing impurities by cleaning the n-type monocrystalline silicon substrate, a substantially intrinsic i-type amorphous silicon layer and a p-type amorphous silicon layer are formed in this order on n-type monocrystalline silicon substrate by using the RF plasma CVD method. The conditions of the RF plasma CVD method may be at a frequency of about 13.56 MHz, a formation temperature of approximately 100°C - 300°C, a reaction pressure of about 5Pa - 100Pa, and an RF power of about 1 mW/cm² - 500 mW/cm². Subsequently, substrate body 1 is cleaned again.

Next, the transparent conductive film including indium oxide containing hydrogen (H) and cerium (Ce) as impurities, is formed on substrate body 1 by using the ion plating method in an atmosphere of Ar/O₂ gas mixture and steam at a room temperature. A sintered body of In₂O₃ powder that contains a predetermined amount of cerium oxide (CeO₂) powder as a dopant is used for ingredients. In this case, the amount of cerium (Ce) contained in the transparent conductive film can be changed by using the sintered body with varied contents of cerium oxide (CeO₂).

Next, the crystallization of the above-mentioned transparent conductive film is preferably proceeded by annealing at approximately 200°C for about 1 hour, thereby transparent conductive film 2 is prepared. In manufacturing various devices, a separate annealing process may not be required in case the annealing treatment is combined with other manufacturing processes.

From the measurement results of electron backscatter diffraction (EBSD), transmission electron microscopy (TEM), and x-ray diffraction (XRD), transparent conductive film 2 according to the embodiment is found to include pillar-like structures that contain substantially polycrystalline structures, and a very little amount of amorphous portions.

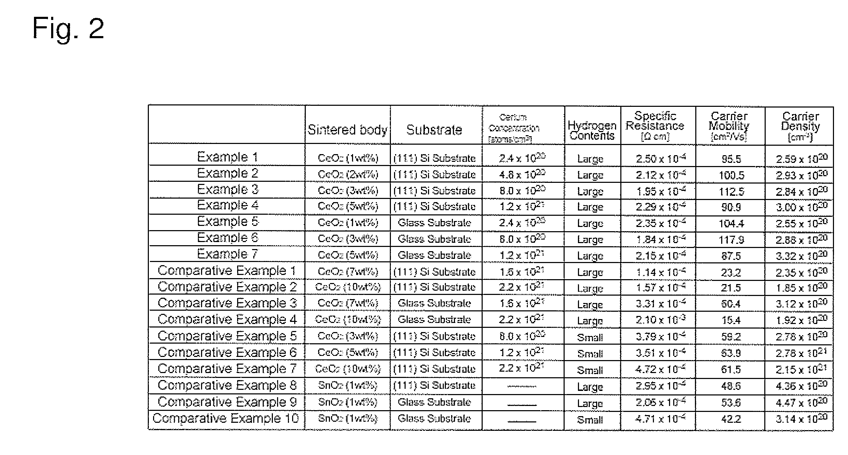

Fig. 2 is a table showing the amount of cerium oxide (CeO₂) in the sintered body used for making respective transparent conductive films, types of substrates used, contents of cerium (Ce) and contents of hydrogen in respective transparent conductive films, the specific resistance of respective transparent conductive films, carrier mobility, and carrier density in examples 1-7 according to the embodiment, and in comparative examples 1-10. Note that the amount of Ce is measured by the Rutherford backscattering spectrometry (RBS) method. The amount of hydrogen is measured by the Hydrogen forward scattering (HFS) method.

The indication of "large" in the column for "hydrogen content" refers to the content of hydrogen in a transparent conductive film being approximately 2.0 x 10²¹ atoms/cm³, and the indication of "small" refers to the content of hydrogen being approximately 9.0 x 10²⁰ atoms/cm³. "(111)Si substrate" refers to a substrate body including an i-type amorphous silicon layer that is substantially intrinsic and has a layer thickness of approximately 5nm and a p-type amorphous silicon layer that is substantially intrinsic and has a layer thickness of approximately 5nm formed on an n-type monocrystalline silicon substrate in this order.

Comparative examples 1-10 are manufactured using the same manufacturing method as in the embodiment except for sintered bodies and the amount of steam. Note that transparent conductive films in comparative examples 1-7 include indium oxide as an essential ingredient and also contains hydrogen (H) and cerium (Ce), and transparent conductive films in comparative examples 8-10 include indium oxide as an essential ingredient and also contains hydrogen (H) and tin (Sn).

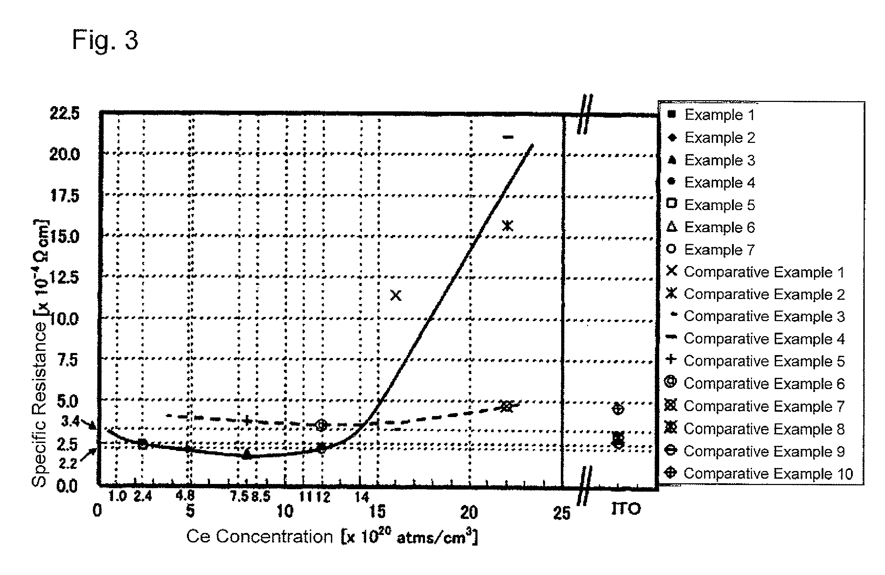

Fig. 3 is a diagram showing the relationship between the specific resistance of the transparent conductive films and the amount of cerium (Ce) in the transparent conducive films in examples 1-7 according to the embodiment, and the transparent conducive films in comparative examples 1-10. In the diagram, the solid line indicates that the amount of hydrogen (H) in the transparent conductive film is 2.0 x 10²¹ atoms/cm³, and the broken line indicates that the amount of hydrogen (H) in the transparent conductive film is 9.0 x 10²⁰ atoms/cm³. Note that the specific resistance is measured according to the Van der Pauw method using a Hall effect measuring device.

Figs. 2 and 3 indicate that where the content of cerium (Ce) in the transparent conductive film is between 1.0 x 10²⁰ atoms/cm³ or more and 1.4 x 10²¹ atoms/cm³ or less, the specific resistance is smaller (i.e., is not greater than 3.4 x 10⁻⁴ when the amount of hydrogen (H) in the transparent conductive film is in the order of 10²¹ atoms/cm³ such as 2.0 x 10²¹ atoms/cm³ compared with that of in the order of 10²⁰ atoms/cm³ such as 9.0 x 10²⁰ atoms/cm³.

Further, when the hydrogen (H) content in the transparent conductive film is in the order of 10²¹ atoms/cm³, such as 2.0 x 10²¹ atoms/cm³, cerium (Ce) content in the transparent conductive film is preferably between 2.4 x 10²⁰ atoms/cm³ or more and 1.2 x 10²¹ atoms/cm³ or less and the specific resistance is not greater than 2.5 x 10⁻⁴ and more preferably is between 4.8 x 10²⁰ atoms/cm³ or more and 1.1 x 10²¹ atoms/cm³ or less and the specific resistance is not greater than 2.2 x 10⁻⁴ and further more preferably is between 7.5 x 10²⁰ atoms/cm³ or more and 1.0 x 10²¹ atoms/cm³ or less, and still further more preferably is between 7.5 x 10²⁰ atoms/cm³ or more and 8.5 x 10²⁰ atoms/cm³ or less.

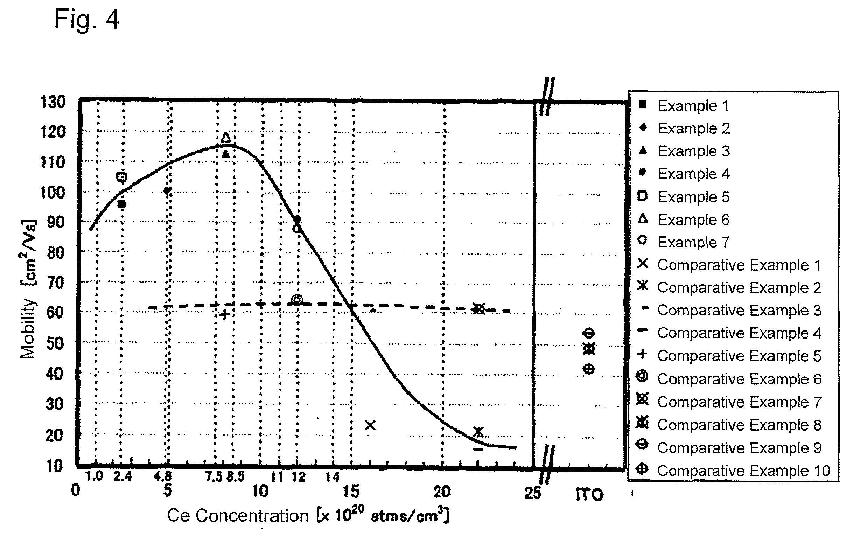

Fig. 4 is a diagram showing the relationship between the carrier mobility in the transparent conductive film and the amount of cerium (Ce) in transparent conductive film 2 in examples 1-7 according to the embodiment, and the transparent conductive films in comparative examples 1-10. In the diagram, the solid line indicates that the amount of hydrogen (H) in the transparent conductive film is 2.0 x 10²¹ atoms/cm³, and the broken line indicate that the amount of hydrogen (H) in the transparent conductive film is 9.0 x 10²⁰ atoms/cm³. Note that the carrier mobility is measured by using a Hall effect measuring device.

A device performs better as an electrode when the carrier mobility value is greater because the specific resistance decreases. Therefore, it is preferable that the carrier mobility value is great.

Figs. 2 and 4 indicate that when the cerium (Ce) content in the transparent conductive film is between 1.0 x 10²⁰ atoms/cm³ or more and 1.4 x 10²¹ atoms/cm³ or less, the carrier mobility is greater (i.e., greater than 70 cm²/Vs) in case the amount of hydrogen (H) in the transparent conductive film is in the order of 10²¹ atoms/cm³ such as 2.0 x 10²¹ atoms/cm³, than in case the amount of hydrogen (H) in the transparent conductive film is in the order of 10²⁰ atoms/cm³ such as 9.0 x 10²⁰ atoms/cm³.

When the amount of hydrogen (H) in the transparent conductive film is in the order of 10²¹ atoms/cm³, such as 2.0 x 10²¹ atoms/cm³, and the cerium (Ce) content in the transparent conductive film is between 1.0 x 10²⁰ atoms/cm³ or more and 1.2 x 10²¹ atoms/cm³ or less, the carrier mobility becomes greater than approximately 90 cm²/Vs which is preferable. It is more preferable that the cerium (Ce) content in the transparent conductive film be between 2.4 x 10²⁰ atoms/cm³ or more and 1.1 x 10²¹ atoms/cm³ or less, and further more preferable that it be between 4.8 x 10²⁰ atoms/cm³ or more and 1.0 x 10²¹ atoms/cm³ or less, and yet further more preferable that the cerium content be between 7.5 x 10²⁰ atoms/cm³ or more, and 8.5 x 10²⁰ atoms/cm³ or less.

In view of the specific resistance and the carrier mobility in the above-mentioned transparent conductive films, the content of cerium (Ce) in the transparent conductive film is preferably between 1.0 x 10²⁰ atoms/cm³ or more and 1.4 x 10²¹ atoms/cm³ or less, and more preferably is between 2.4 x 10²⁰ atoms/cm³ or more and 1.1 x 10²¹ atoms/cm³ or less, and further more preferably between 4.8 x 10²⁰ atoms/cm³ or more and 1.0 x 10²¹ atoms/cm³ or less, and still further more preferably, between 7.5 x 10²⁰ atoms/cm³ or more, and 8.5 x 10²⁰ atoms/cm³ or less.

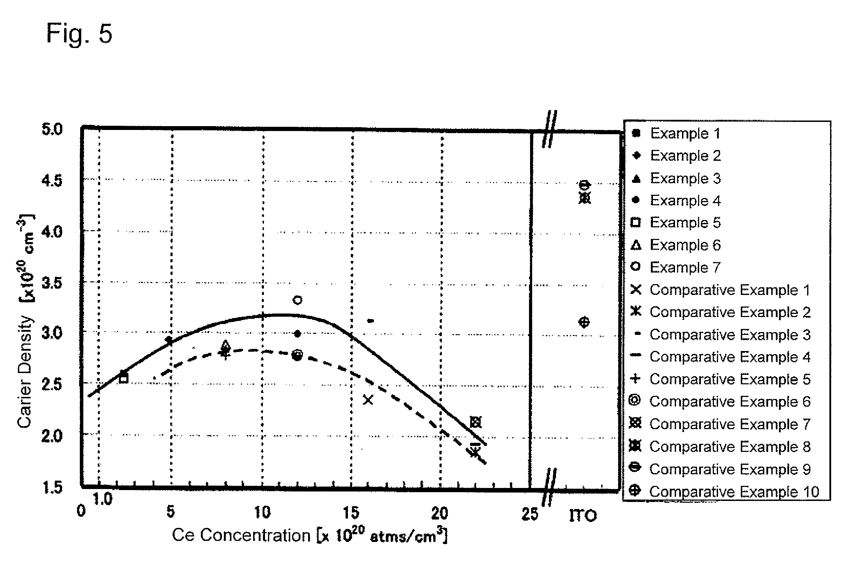

Fig. 5 is a diagram showing the relationship between the carrier density and the amount of cerium (Ce) in transparent conductive film 2 in examples 1-7, and in transparent conductive films in comparative examples 1-10. In the diagram, the solid line indicates that the amount of hydrogen (H) in the transparent conductive film is 2.0 x 10²¹ atoms/cm³, and the broken line indicates that the amount of hydrogen (H) in the transparent conductive film is 9.0 x 10²⁰ atoms/cm³. Note that the carrier mobility is measured using a Hall effect measuring device.

As to the carrier density, when a value of the carrier density is higher, the light with a longer wavelength is absorbed. Also, carriers themselves cause scattering. As a result, the carrier mobility is decreased. Therefore, when the specific resistance has the same value, it is preferable that the carrier density be lower. However, when the carrier density is too low, the grain boundary scattering within the film increases which results in the decrease of the carrier mobility. Therefore, it is preferable that the carrier density be within a predetermined range.

Figs. 2 and 5 indicate that when the cerium (Ce) content in the transparent conductive film is between 1.0 x 10²⁰ atoms/cm³ or more and 2.0 x 10²¹ atoms/cm³ or less, the carrier density is between 2.0 x 10²⁰ cm⁻³ or more and 3.5 x 10²⁰ cm⁻³ or less, and is in an excellent range. However, even within this content range, it is further preferable that the cerium (Ce) content be in the higher concentration or in the lower concentration of the range.

Note that Figs. 2-4 indicate that the transparent conductive films in comparative examples 8-10 including indium oxide as an essential ingredient and also containing hydrogen (H) and tin (Sn) exhibit the low specific resistance; however, the carrier mobility is not greater than 60 cm²/Vs. This result shows that transparent conductive films including indium oxide as an essential ingredient and also contains hydrogen (H) in the order of 10²¹ atoms/cm³ and cerium (Ce) is preferable.

The transparent conductive film according to the present invention can be properly used in display devices such as liquid display devices, organic electroluminescence devices, solar cell devices such as crystalline solar cells, thin film solar cells, dye-sensitized solar cells, and electronic components.

For example, the transparent conductive film including a transparent conductive film having a texture structure, a first type amorphous silicon layer, a substantially intrinsic i-type amorphous silicon layer, and another amorphous silicon layer having an opposite type to the first type, and a transparent conductive film formed on a glass substrate, in this order, may be used in a thin film solar cell.

### POTENTIAL USE IN THE INDUSTRY

The invention can be used in the fields of display devices such as liquid display devices, organic electroluminescence devices, solar cell devices such as crystalline solar cells, thin film solar cells, dye-sensitized solar cells, and electronic components, because the invention provides a transparent conductive film capable of absorbing less light of the long-wavelength side, having good carrier mobility and lowering the electric resistance, and a device with the same.

### EXPLANATION OF REFERENCE NUMBER

- 1: Substrate body
- 2: Transparent conductive film

## Claims

1. A transparent conductive film **characterized by** comprising indium oxide containing hydrogen and cerium and having a substantially polycrystalline structure, wherein a specific resistance is no greater than 3.4 x 10⁻⁴

2. The transparent conductive film according to claim 1, wherein a cerium content is **characterized by** being between 1.0 x 10²⁰ atoms/cm³ or more and 1.4 x 10²¹ atoms/cm³ or less.

3. The transparent conductive film according to claim 1, wherein a hydrogen content is **characterized by** being in the order of 10²¹ atoms/cm³.

4. A device **characterized by** using the transparent conductive film according to any one of claims 1-3.

5. A solar cell **characterized by** using the transparent conductive film according to any one of claims 1-3.
